(19) Europäisches Patentamt
European Patent Office
Office européen des brevets

(11) **EP 1 158 660 A1**

(12) **DEMANDE DE BREVET EUROPEEN**

(43) Date de publication:
**28.11.2001 Bulletin 2001/48**

(51) Int Cl.[7]: **H03D 7/14**

(21) Numéro de dépôt: **01401319.7**

(22) Date de dépôt: **21.05.2001**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **25.05.2000 FR 0006692**

(71) Demandeur: **ALCATEL**
**75008 Paris (FR)**

(72) Inventeurs:
• **Villemazet, Jean-François**
**31550 Cintegabelle (FR)**
• **Rogeaux, Eric**
**31830 Plaisance du Touch (FR)**

(74) Mandataire: **Smith, Bradford Lee et al**
**COMPAGNIE FINANCIERE ALCATEL**
**Dépt. Propr. Industrielle,**
**30, avenue Kléber**
**75116 Paris (FR)**

(54) **Mélangeur doublement équilibré en technologie MMIC**

(57)    Mélangeur doublement équilibré de signaux hautes fréquences incluant un quad de transistors froids et des coupleurs 180° aux entrées et en sortie de quad, caractérisé en ce que le quad (1) est constitué de quatre transistors (2 à 5) disposés dans une configuration en ligne attaquée en son milieu par le signal RF à traiter et à chacune de ses extrémités par un signal $\overline{RF}/2$ déphasé de 180° par rapport au signal RF.

Ce mélangeur est prévu pour être réalisé en technologie MMIC et pour fonctionner en bande L, S, C, X ou Ku.

**FIG. 1**

EP 1 158 660 A1

**Description**

L'invention concerne un mélangeur de signaux hautes fréquences doublement équilibré et, en particulier, un mélangeur réalisable sous forme compacte et destiné à être incorporé dans un circuit intégré monolithique de technologie MMIC (Monolithic Microwave Integrated Circuit).

Un mélangeur, doublement équilibré, réalisable sous forme compacte et destiné à être incorporé dans un circuit intégré, est décrit dans le document FR-A-2762942. Comme rappelé dans ce document, un tel mélangeur est un dispositif qui permet de convertir la fréquence d'un signal d'entrée, tel qu'un signal radiofréquence RF, en un signal de sortie à fréquence plus basse, dit signal à fréquence intermédiaire FI, avec l'aide d'un signal d'oscillateur local OL. La fréquence du signal de sortie correspond théoriquement à la différence entre la fréquence du signal RF et la fréquence du signal oscillateur local OL. En pratique le signal de sortie, qui est généré, a un spectre incluant une pluralité de fréquences définies par l'expression :

$$n.F_{RF} \pm m.F_{OL}, \text{ où m et n sont des nombres entiers.}$$

Pour éliminer les fréquences parasites obtenues, en plus de la fréquence intermédiaire FI en sortie d'un mélangeur, il est habituel de placer des coupleurs 180° au niveau des accès d'entrée et de sortie du mélangeur pour éliminer ces fréquences parasites en les combinant en opposition de phase.

Le mélangeur inclut des éléments, non linéaires, disposés de manière particulière et par exemple quatre diodes en anneau dans une configuration couramment dite quad, ou en étoile. Un quad en anneau de quatre transistors froids est ainsi prévu dans le mélangeur doublement équilibré que décrit le document FR-A-2762942, déjà mentionné ci-dessus. Les coupleurs 180° peuvent être réalisés sous différentes formes, une des structures les plus connues se présentant sous la forme d'un anneau hybride, dit "Rat-Race". Cet anneau est constitué par une ligne microruban ayant une circonférence égale à 1,5λ, au long de laquelle les sorties sont réparties au pas de λ/4 correspondant au quart de la longueur d'onde du signal traité.

Une telle structure devient inacceptable, si le mélangeur doit être inclus dans un circuit monolithique en technologie MMIC, car l'encombrement matériel devient trop important.

Le mélangeur divulgué dans le document FR-A-2762942 est conçu de manière à présenter un encombrement nettement moindre que celui des mélangeurs antérieurs évoqués ci-dessus. Ce mélangeur se compose d'un quad de transistors froids directement connectés à deux coupleurs fonctionnant respectivement aux fréquences RF et FI. Ces coupleurs sont basés sur une structure à trois lignes couplées, en technologie microruban, d'une longueur de λ/16 au lieu du classique λ/4. Il est ainsi possible de réaliser un mélangeur compact sur un substrat d'AsGa avec un encombrement cinq fois moindre que précédemment. Toutefois cette solution à quad en anneau de transistors froids n'est pas aisément transposable en technologie coplanaire. Il n'est donc pas actuellement possible de profiter des avantages, notamment en matière de réduction des coûts, qui sont susceptibles d'être obtenus par la mise en oeuvre de cette technologie. Or on sait que cette technologie coplanaire permet d'éviter le traitement de la face arrière des circuits intégrés monolithiques réalisés. Elle permet, par ailleurs, un montage des puces de circuits intégrés en mode dit "Flip-Chip", ce qui rend possible le câblage automatique et ce qui est favorable à la montée en fréquence des montages ainsi réalisés.

L'invention propose donc un mélangeur doublement équilibré prévu pour être réalisé en exploitant la technologie coplanaire, afin d'obtenir un encombrement réduit par rapport aux réalisations antérieures, ainsi qu'un gain de conversion se substituant aux pertes habituellement obtenues. Ce mélangeur, doublement équilibré, de signaux hautes fréquences inclut un quad de transistors froids et des coupleurs 180° aux entrées et en sortie de quad.

Selon une caractéristique de l'invention, le quad est constitué de quatre transistors disposés dans une configuration en ligne attaquée en son milieu par le signal RF à traiter et à chacune de ses extrémités par un signal $\overline{RF}/2$ déphasé de 180° par rapport au signal RF.

Selon une forme de réalisation de l'invention, les coupleurs s 180° sont reliés au quad par l'intermédiaire de liaisons coplanaires, de type ligne à ruban CPS ou guide d'ondes CPW.

Selon une forme de réalisation de l'invention, le quad est constitué de deux groupes de deux transistors reliés par leurs drains dans lesquels les deux transistors, de groupes différents, qui sont situés en milieu d'alignement sont reliés par leur source, le point commun à ces deux sources recevant le signal RF à traiter, les sources des deux transistors situés aux extrémités de l'alignement recevant chacune un signal $\overline{RF}/2$, déphasé de 180° par rapport au signal RF, les signaux à fréquence intermédiaire FI et $\overline{FI}$ obtenus par traitement étant fournis aux niveaux de l'interconnexion entre drains réalisés pour les deux transistors de chacun des groupes.

Selon une forme de réalisation de l'invention, le coupleur radiofréquence comporte trois coupleurs 180°, de type drain-source, formant un groupe comprenant un coupleur d'entrée et deux coupleurs de sortie qui est agencé pour fournir au quad un signal radiofréquence RF au niveau d'une première sortie et deux signaux $\overline{RF}/2$ identiquement déphasés de 180° par rapport au signal RF au niveau de deux autres sorties distinctes et interconnectées. Ces signaux sont obtenus par sommation sélective des signaux de sortie obtenus de deux coupleurs de sortie du groupe qui reçoivent chacun l'un des signaux déphasés de 180° respectivement fournis par le coupleur d'entrée, via le drain et la source d'un transistor, à partir d'un signal radiofréquence fourni à ce coupleur d'entrée et appliqué à la grille du transistor. Les deux coupleurs de sortie sont montés de manière que le drain d'un premier et la source du second soient reliés au potentiel de masse, via chacun une résistance, alors que la source du premier et le drain du second sont reliés, via d'autres résistances chacun à un même potentiel, négatif pour la première et positif pour l'autre. Le signal radiofréquence apparaissant au niveau de la source du transistor du premier des coupleurs de sortie est combiné par liaison capacitive avec le signal radiofréquence apparaissant au niveau du drain du transistor du second de ces coupleurs de sortie pour constituer le signal RF. Les signaux radiofréquences apparaissant respectivement au niveau du drain du premier coupleur de sortie et au niveau de la source du second coupleur de sortie sont distribués au niveau de deux sorties qui fournissent chacune un signal $\overline{RF}$/2 et qui sont interconnectées à des fins d'équilibrage électrique.

Selon une forme de réalisation de l'invention, le quad et les coupleurs sont réalisés en technologie MMIC ou hybride.

L'invention, ses caractéristiques et ses avantages sont précisés dans la description qui suit en liaison avec les figures évoquées ci-dessous.

La figure 1 présente un schéma d'un quad, pour mélangeur, qui est composé de transistors froids, organisés en ligne et alimentés selon un agencement propre à l'invention.

La figure 2 présente un schéma d'un coupleur radiofréquence pour mélangeur qui est destiné à être associé à un quad, tel qu'illustré sur la figure 1.

La figure 3 présente une reproduction d'une partie de masque relative à un mélangeur en technologie MMIC, selon l'invention.

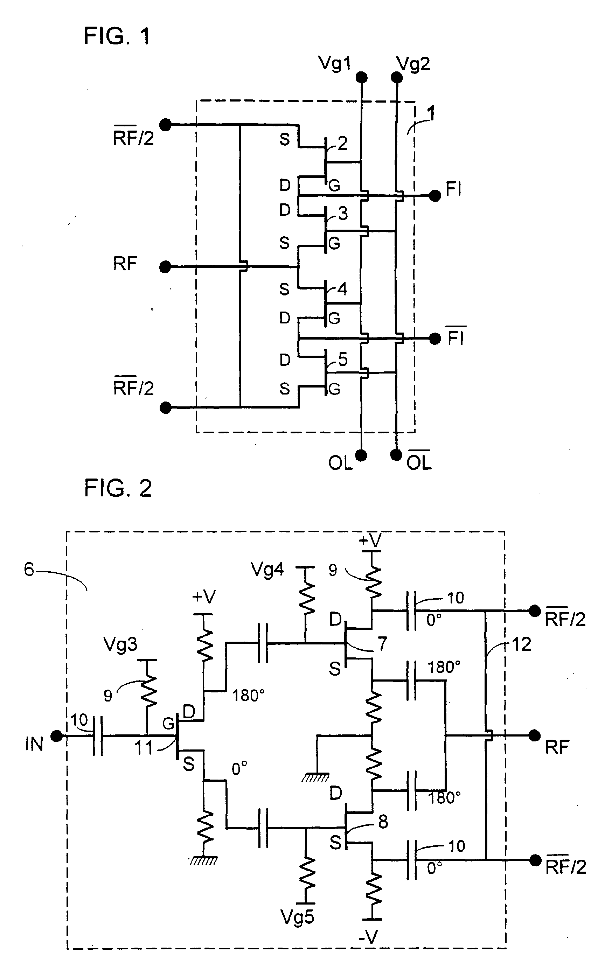

Le quad 1, pour mélangeur de signaux hautes fréquences qui est illustré sur la figure 1, comporte quatre transistors 2 à 5 disposés dans une configuration "en ligne", sur le modèle de l'empilement des doigts de grille, drain et source d'un transistor. Ces transistors sont par exemple des transistors froids, de type PHEMT (Pseudomorphic High Electron Mobility Transistor). Un tel quad en ligne permet de réaliser une configuration particulièrement compacte et une interconnexion à l'aide de guides coplanaires. L'alignement formé par les transistors comporte deux groupes de deux transistors, soit ici le groupe des transistors 2 et 3 et celui des transistors 4 et 5, dans chacun desquels les transistors sont reliés par leurs drains D. Les transistors 3 et 4 situés en milieu d'alignement sont reliés par leurs sources S. Des tensions de polarisation Vg1 et Vg2, éventuellement identiques, sont respectivement appliquées l'une aux grilles G des transistors 2 et 4, l'autre aux grilles des transistors 3 et 5. L'injection dans le quad 1 du signal radiofréquence RF à traiter est réalisé par l'intermédiaire de trois accès, qui correspondent respectivement, l'un, au point commun aux sources S interconnectées des transistors 3 et 4, situés en milieu d'alignement, et, les deux autres, aux sources S des transistors 2 et 5 qui constituent les extrémités de l'alignement formé par le quad 1. L'accès correspondant au point commun est destiné à recevoir le signal RF qui lui est fourni par l'intermédiaire d'un coupleur radiofréquence, tel que défini plus loin, alors que chacun des deux accès d'extrémité est destiné à recevoir un signal $\overline{RF}$/2 déphasé de 180° par rapport au signal RF provenant du coupleur radiofréquence. Dans une forme préférée de réalisation, une ligne de transmission relie les sources des transistors 2 et 5.

L'injection dans le quad du signal oscillateur local OL nécessaire au traitement du signal radiofréquence RF est réalisé par l'intermédiaire de deux accès qui correspondent chacun à une des liaisons par l'intermédiaire des quelles les grilles des transistors 2 à 5 sont polarisées comme indiqué ci-dessus. Dans l'exemple de réalisation schématisé, le signal OL est appliqué aux grilles des transistors 2 et 4 et un signal $\overline{OL}$ déphasé de 180° par rapport au signal OL est appliqué aux grilles des transistors 3 et 5.

Le signal à fréquence intermédiaire FI obtenu par traitement du signal radiofréquence au niveau du quad 1 et son complément $\overline{FI}$ sont respectivement fournis chacun par un accès qui correspond au point commun aux drains d'un des groupes respectivement constitués par les transistors 2 et 3, pour l'un des groupes, et, par les transistors 4 et 5, pour l'autre.

Comme indiqué plus haut, il est prévu que le quad 1 soit relié, par l'intermédiaire de lignes coplanaires, aux trois coupleurs qui permettent respectivement d'injecter le signal oscillateur local et le signal radiofréquence à traiter, ainsi que de récupérer le signal à fréquence intermédiaire, aux niveaux des accès définis ci-dessus.

La disposition alignée des transistors du quad 1 ne permet pas d'obtenir directement la symétrie qu'offre un quad en anneau. Selon l'invention, il est prévu de mettre en oeuvre un coupleur RF permettant d'alimenter simultanément les extrémités de l'alignement formé par les transistors du quad 1, pour éviter la dégradation du comportement aux fréquences micro-ondes de fonctionnement qui se produirait si les extrémités du quad étaient seulement refermées via une ligne.

Ce coupleur RF, référencé 6, comporte trois sorties, soit une sortie RF et deux sorties $\overline{RF}$/2, c'est préférablement un coupleur exploitant les propriétés des coupleurs 180° actifs, de type drain-source.

Comme il est connu, un coupleur drain-source a habituellement des performances assez faibles en matière d'écart d'amplitude et de phase, entre sorties, en raison de la dissymétrie qu'il présente, comme le montre le schéma électrique équivalent du transistor qu'il comporte, si l'on en considère les accès drain et source.

Pour pallier cet inconvénient, il est donc prévu, selon l'invention, de sommer les sorties de deux coupleurs drain-source, comme représenté sur la figure 2 où un coupleur RF référencé 6 comporte deux transistors 7 et 8 qui sont associés de manière à être exploités de cette façon. Pour ceci, le transistor 7 est relié par son drain à un potentiel positif déterminé +V, par exemple 5 volts, et par sa source à un potentiel de masse, alors que le transistor 8 est relié par son drain au potentiel de masse et par sa source à un potentiel négatif égal à -V, chacun via une des résistances ici globalement référencées 9. La source S du transistor 7 et le drain D du transistor 8 sont couplés entre eux, via des condensateurs, ici globalement référencés 10, pour constituer la sortie RF du coupleur 6. Le drain D du transistor 7 et la source S du transistor 8 sont exploités pour fournir un signal $\overline{RF}$/2 chacun à une sortie du coupleur 6, via un condensateur 10. Pour assurer un équilibrage électrique autorisant un fonctionnement du coupleur 6 à fréquence élevée, il est prévu de relier les deux sorties de signal $\overline{RF}$/2, au-delà des condensateurs 10 par rapport aux transistors 7 et 8, par l'intermédiaire d'une liaison d'interconnexion 12. Un équilibrage naturel est donc obtenu par l'utilisation d'un même schéma électrique pour les deux voies d'accès du coupleur 6 au quad 1, ce qui se traduit donc par une réduction des écarts parasites d'amplitude et de phase entre les signaux transmis par l'intermédiaire de ces voies.

L'obtention d'une association, en phase et deux à deux, des sorties des deux coupleurs de sortie, constitués autour des transistors 7 et 8, implique l'utilisation d'un coupleur d'entrée permettant d'exciter ces transistors 7, 8 avec un déphasage approprié. Ce coupleur d'entrée est ici supposé être un autre coupleur à 180°, de type drain-source, constitué autour d'un transistor 11.

La grille du transistor 11 reçoit le signal radiofréquence à traiter, via un accès IN, elle est soumise à une tension de polarisation Vg3. Le drain du transistor 11 est soumis à la tension +V, via une résistance 9, et il est relié, via un condensateur 10, à la grille du transistor 7 qui est elle-même soumise à la tension de polarisation Vg4. La source du transistor 11 est reliée, d'une part, à la masse, via une des résistances 9, et d'autre part, à la grille du transistor 8, via un des condensateurs 10, cette grille étant soumise à la tension de polarisation Vg5.

Dans la forme de réalisation envisagée ici, un mélangeur équilibré selon l'invention incorpore un quad en ligne, tel que le quad 1 défini ci-dessus et un coupleur radiofréquence à trois sorties, tel que le coupleur 6 également défini ci-dessus. Ce quad et ce coupleur sont associés à un coupleur à deux entrées d'injection d'un signal à fréquence locale et à un coupleur à deux accès d'extraction de signal à fréquence intermédiaire.

La mise en oeuvre d'une technologie coplanaire pour l'ensemble du mélangeur, selon l'invention, permet de réaliser un montage de très grande compacité qui est aisément intégrable dans un circuit intégré monolithique MMIC, exploitable à fréquence élevée, par exemple en bande Ku. Le mélangeur ainsi obtenu a pour caractéristique supplémentaire de présenter un gain de conversion qui peut, par exemple, atteindre une valeur de l'ordre de +4dB, au lieu des pertes, typiquement de l'ordre de -12dB, qui sont obtenues dans le cas d'un mélangeur connu.

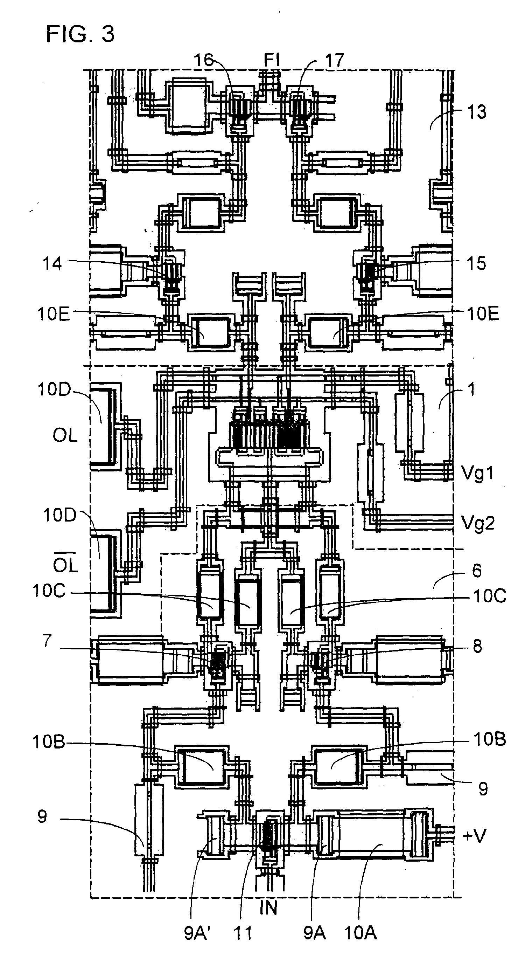

L'extrait de masque relatif au mélangeur, selon l'invention, qui est présenté sur la figure 3, montre trois sous-ensembles alignés correspondant de bas en haut au coupleur radiofréquence RF référencé 6, au quad 1 et au coupleur à la fréquence intermédiaire FI. Le signal radiofréquence reçu par le mélangeur est appliqué au niveau d'un accès référencé IN du coupleur radiofréquence 6 dans lequel les différentes liaisons sont de type guide d'ondes coplanaire CPW. Ce signal radiofréquence est appliqué au niveau de la grille du transistor 11 du coupleur radiofréquence 6. Le drain du transistor 11 est relié au potentiel +V, au travers d'une résistance 9A et via une capacité 10A, la source du transistor 1 1 est reliée à la masse via la résistance 9A'. La source et le drain du transistor 11 sont respectivement reliés chacun à la grille d'un des transistors 7 et 8, via chacun une capacité 10B, ces deux dernières grilles étant respectivement reliées aux potentiels Vg4 et Vg5, via des résistances 9. Le quad 1 qui comporte des liaisons de type ligne à ruban CPS est relié au drain et à la source de chacun des transistors 7 et 8 du coupleur radiofréquence 6, via des capacités 10C, ici supposées réalisées au niveau de ce coupleur, par lesquelles sont transmis le signal RF et les signaux $\overline{RF}$/2. Comme indiqué précédemment le quad 1 reçoit, via deux capacités 10D partiellement représentées, les signaux d'oscillateur local OL et $\overline{OL}$ qui sont appliqués aux grilles des quatre transistors en ligne qu'il comporte. Les signaux déphasés à fréquence intermédiaire FI et $\overline{FI}$ produits par le quad sont respectivement appliqués chacun à la grille d'un transistor d'entrée 14 ou 15 d'un montage cascode, via une capacité 10E. Le montage comporte deux transistors de sortie 16 ou 17 interconnectés au niveau de leurs sources respectives pour fournir le signal intermédiaire FI à partir de la combinaison des signaux FI et $\overline{FI}$ appliqués aux grilles des transistors d'entrée 14 et 15, les grilles des transistors 16 et 17 étant respectivement reliées capacitivement chacune au drain d'un des deux transistors d'entrée 14, 15, selon un montage connu de l'homme de métier.

## Revendications

1. Mélangeur doublement équilibré de signaux hautes fréquences incluant un quad de transistors froids et des coupleurs 180° aux entrées et en sortie de quad, **caractérisé en ce que** le quad (1) est constitué de quatre transistors (2 à 5) disposés dans une configuration en ligne attaquée en son milieu par le signal RF à traiter et à chacune de ses extrémités par un signal $\overline{RF}/2$ déphasé de 180° par rapport au signal RF.

2.  Mélangeur, selon la revendication 1, dans lequel le quad est constitué de deux groupes de deux transistors (2 et 3, 4 et 5) reliés par leurs drains dans lesquels les deux transistors (3 et 4), de groupes différents, qui sont situés en milieu d'alignement sont reliés par leur source (S), le point commun à ces deux sources recevant le signal RF à traiter, les sources (S) des deux transistors (2 et 5) situés aux extrémités de l'alignement recevant chacune un signal $\overline{RF}/2$, déphasé de 180° par rapport au signal RF, les signaux à fréquence intermédiaire FI et $\overline{FI}$ obtenus par traitement étant fournis aux niveaux de l'interconnexion entre drains (D) réalisés pour les deux transistors (2 et 3 ou 4 et 5) de chacun des groupes.

3.  Mélangeur, selon l'une des revendications 1, 2, dans lequel le coupleur radiofréquence RF comporte trois coupleurs 180°, de type drain-source, formant un groupe comprenant un coupleur d'entrée et deux coupleurs de sortie qui est agencé pour fournir au quad (1) un signal radiofréquence (RF) au niveau d'une première sortie et deux signaux $\overline{RF}/2$ identiquement déphasés de 180° par rapport au signal RF au niveau de deux autres sorties distinctes et interconnectées, ces signaux étant obtenus par sommation sélective des signaux obtenus en sortie de deux coupleurs de sortie du groupe qui reçoivent chacun l'un des signaux déphasés de 180° respectivement fournis par le coupleur d'entrée, via le drain et la source d'un transistor (11), à partir d'un signal radiofréquence fourni à ce coupleur d'entrée et appliqué à la grille du transistor (11), les deux coupleurs de sortie étant montés de manière que le drain d'un premier et la source du second soient reliés au potentiel de masse, via chacun une résistance (9), alors que la source du premier et le drain du second sont reliés, via chacun une résistance (9), à un même potentiel, négatif pour le premier et positif pour l'autre, le signal radiofréquence apparaissant au niveau de la source du premier des coupleurs de sortie (transistor 7) étant combiné par liaison capacitive avec le signal radiofréquence apparaissant au niveau du drain du second de ces coupleurs de sortie (transistor 8) pour constituer le signal RF, les signaux radiofréquences apparaissant respectivement au niveau du drain du premier coupleur de sortie et au niveau de la source du second coupleur de sortie sont distribués au niveau de deux sorties qui fournissent chacune un signal $\overline{RF}/2$ et qui sont interconnectées à des fins d'équilibrage électrique.

4.  Mélangeur, selon l'une des revendications 1 à 4, dans lequel les coupleurs 180° d'insertion et d'extraction de signaux (RF et $\overline{RF}/2$, OL et $\overline{OL}$, FI et $\overline{FI}$) sont reliés au quad par l'intermédiaire de liaisons coplanaires, de type ligne à ruban CPS ou guide d'ondes CPW.

5.  Mélangeur, selon l'une des revendications 1 à 4, dans lequel le quad et les coupleurs sont réalisés en technologie MMIC.

6.  Mélangeur, selon l'une des revendications 1 à 3, dans lequel le quad et les coupleurs sont réalisés en technologie hybride.

FIG. 1

FIG. 2

## FIG. 3

**Office européen des brevets**

# RAPPORT DE RECHERCHE EUROPEENNE

Numéro de la demande

EP 01 40 1319

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | US 5 060 298 A (R. WAUGH) 22 octobre 1991 (1991-10-22) * colonne 5, ligne 1 - ligne 32; figure 2 * --- | 1 | H03D7/14 |
| A | US 5 039 891 A (C. WEN) 13 août 1991 (1991-08-13) * colonne 5, ligne 40 - colonne 6, ligne 18; figure 6 * --- | 1 | |
| A | T. TOKOMITSU: "divider and combiner line unifies fets as basic circuit function modules part 2" IEEETRANSACTIONS ON MICROWAVE THEORY AND TECHNIQUES, vol. 38, no. 9, 1 septembre 1990 (1990-09-01), pages 1218-1226, XP000142217 new york ,us * figures 11,16,19 * ----- | 1 | |

**DOMAINES TECHNIQUES RECHERCHES (Int.Cl.7)**

H03D

Le présent rapport a été établi pour toutes les revendications

| Lieu de la recherche | Date d'achèvement de la recherche | Examinateur |
|---|---|---|
| LA HAYE | 6 juillet 2001 | Butler, N |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 01 40 1319

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-07-2001

| Document brevet cité au rapport de recherche | | Date de publication | Membre(s) de la famille de brevet(s) | Date de publication |
|---|---|---|---|---|
| US 5060298 | A | 22-10-1991 | AUCUN | |
| US 5039891 | A | 13-08-1991 | AUCUN | |

EPO FORM P0460

Pour tout renseignement concernant cette annexe : voir Journal Officiel de l'Office européen des brevets, No.12/82